# EUROPÄISCHE PATENTSCHRIFT

(11) **EP 3 962 849 B1**
(45) Veröffentlichungstag und Bekanntmachung des Hinweises auf die Patenterteilung: **22.03.2023**
(21) Anmeldenummer: 20720102.1
(22) Anmeldetag: 27.04.2020
(51) Int. Cl.: B66B 1/46

(54) **AUFZUGSBEDIENPANEL UND DESSEN OPERATIONSVERFAHREN**
ELEVATOR PANEL AND ITS METHOD OF OPERATION
PANNEAU DE COMMANDE D'ASCENSEUR ET SON PROCÉDÉ DE FONCTIONNEMENT

(30) Priorität: 30.04.2019 EP 19171961
(43) Veröffentlichungstag der Anmeldung: 09.03.2022
(73) Patentinhaber: INVENTIO AG, 6052 Hergiswil (CH)
(72) Erfinder: BONOMI, Pietro, 28925 Verbania (IT)
(74) Vertreter: Inventio AG
(86) Internationale Anmeldenummer: PCT/EP2020/061630
(87) Internationale Veröffentlichungsnummer: WO 2020/221697

(56) Entgegenhaltungen:
- EP-A1- 0 320 583
- WO-A1-2007/046168
- JP-A- S63 212 684

## Beschreibung

Die vorliegende Erfindung betrifft ein Verfahren zum Bedienen eines Aufzugs und ein Bedienpanel für einen Aufzug zum Ausführen des Verfahrens sowie einen Aufzug mit einem derartigen Bedienpanel bzw. Computerprogrammprodukt dieses Verfahren veranlasst und ein Computerlesbares Medium mit dem darauf gespeicherten Computerprogrammprodukt.

Aufzuganlagen dienen dazu, Personen und/oder Waren durch Aufzugskabinen innerhalb eines Gebäudes zwischen verschiedenen Stockwerken zu befördern. Speziell in Aufzugsanlagen werden Bedienpanele, auch Tableaus genannt, eingesetzt. Ein Aufzugsbedienpanel ist als COP (Car Operation Panel) innerhalb oder als LOP (Landing Operation Panel) außerhalb der Aufzugskabine bekannt, das verschiedene Tasten zur Eingabe eines Kabinenrufes oder Stockwerksrufes aufweist. Ein solches Bedienpanel muss sehr vielen und sogar zum Teil gegenläufigen Anforderungen entsprechen. Einerseits sollte das Bedienpanel funktionssicher sein, andererseits wird erwartet, dass sie kostengünstig sind. Vermehrt spielt heute auch die Ästhetik eine wichtige Rolle. Die Bedienpanel müssen also optisch ansprechend sein und sie sollen an das Design des Aufzugs anpassbar sein. Deshalb besteht es derzeit ein Trend, immer mehr kapazitiven Bedienpanel zu verwenden, und mechanische Tasten werden zunehmend häufiger durch kapazitive Tasten ersetzt. Und die sogenannten kapazitiven Touchscreens finden dabei eine gute Anwendung. Im Gegensatz zu einem herkömmlichen resistiven Touchscreen funktioniert ein kapazitiver Touchscreen auch ohne Druck. Sie müssen ihn lediglich berühren, um zu interagieren. Eine aus einem elektrischen Feld, das auf eine Berührung reagiert, sich ergebende Kapazitäts- oder Ladungsänderung einer kapazitiven Taste wird erfassen, damit eine Betätigung einer Taste ermittelt werden kann.

Ein Nachteil von kapazitiven Tasten ist jedoch deren unbeabsichtigtes Auslösen. Mechanische Tasten leisten haptischen Widerstand, eine kapazitive Taste hingegen kann unwillentlich und unbemerkt ausgelöst werden. Ein Alltagsbeispiel verdeutlicht diese unzureichende Bediensicherheit, wie z.B. ein Passagier könnte streift mit seinem Arm oder seinem Rucksack unbemerkt eine Taste von einem Bedienpanel und wählt somit unbeabsichtigt eine ungewünschte Etage, eine Türöffnung (DTO: Door To Open), eine Türschließung (DTS: Door To Shut) oder eine Störungsmeldung.

Zum anderen sind die kapazitiven Tasten periodisch oder in einem Fall, wenn eine gemessene Kapazität von einem Sollwert bzw. einem Toleranzbereich abweicht, zu kalibrieren, weil mit der Zeit eine Kapazitätsdrift aufgrund äußerer Einflüsse, z.B. statischer Elektrizität, Feuchtigkeit oder Temperaturschwankungen, auftreten könnten. Aufgrund spezifischer Anforderungen an Aufzüge muss ein Aufzug durch ein Bedienpanel zuverlässig gesteuert werden. Falls ein kapazitives Bedienpanel sich nicht zwischen einer Betätigung und einer Fehlbedienung einer Funktionstaste unterscheiden kann, könnte eine Kalibrierung zu einer schwerwiegenden Folge führen. Angenommen wird, dass ein Mann eine Türöffnungstaste (DTO) von einem COP dauerhaft drückt und damit eine abzufahrende Kabine auf jemanden noch warten lässt. Falls das COP diese dauerhafte Betätigung als eine Störung ermittelt, wird eine Kalibrierung durchgeführt. In diesem Fall könnte eine kritische Situation auftreten, wie z.B. eine Schachttür wird trotz der betätigt gehaltenen DTO-Taste überraschend geschlossen oder die Kabine fährt mit einer geöffneten Tür weg. In diesem Fall bestünde ein Risiko, dass Personen durch die Schachttür hindurchtreten und in den geöffneten Aufzugschacht stürzen könnten. Die WO 2007/046168 A1 und EP 0 320 583 A1 offenbaren Verfahren und Bedienpanele nach dem Stand der Technik.

Es wurde erkannt, dass für zukünftige Anwendungen, wie sie weiter unten detaillierter beschrieben werden, ein Bedarf an insbesondere ein kapazitives Bedienpanel für eine Aufzuganlage bestehen kann, bei denen nicht nur eine momentane oder eine dauerhafte Betätigung zuverlässig erkannt und gewährleitet, sondern auch unbeabsichtigte Betätigungen als Störungen ignoriert werden können. Ferner kann ein Bedarf an einer Aufzuganlage mit einem solchen Bedienpanel bestehen.

Einem solchen Bedarf kann durch den Gegenstand gemäß einem der unabhängigen Ansprüche entsprochen werden. Vorteilhafte Ausführungsformen sind in den abhängigen Ansprüchen sowie der nachfolgenden Beschreibung definiert.

Mögliche Merkmale und Vorteile von Ausführungsformen der Erfindung können unter anderem und ohne die Erfindung einzuschränken als auf nachfolgend beschriebenen Ideen und Erkenntnissen beruhend angesehen werden.

Gemäß einem ersten Aspekt der Erfindung wird ein Verfahren zum Bedienen eines Aufzugs mit einem Bedienpanel, wobei das Bedienpanel mehrere kapazitive Tasten und eine Steuereinheit aufweist, welche eine Kapazitätsänderung der kapazitiven Tasten zur Erkennung einer Betätigung der Taste auswertet. Wenn eine Betätigung einer ersten Taste erkannt wird, die Betätigungsdauer dieser ersten Taste eine vorgegebene erste Zeitperiode überschreitet, und eine Betätigung mindestens einer zweiten, zu der ersten Taste benachbart angeordneten Taste erkannt wird, wird die Betätigung der ersten Taste dann anhand einer Kapazitätsänderung der betätigten zweiten Taste derart gesteuert wird, dass die Steuereinheit die Betätigung der ersten Taste annulliert, falls die Betätigung der zweiten Taste während einer vorgegebenen Prüfperiode andauert. Die Steuereinheit wird die Betätigung der ersten Taste bleibend hält, wenn keine Kapazitätsänderung der zweiten Taste in der Prüfperiode erfolgt. Durch ein durch ein derartiges Verfahren bedientes Bedienpanel kann der obengenannte bestehende Bedarf für eine Aufzuganlage erfüllt werden, und eine Fehlbedienung, die durch das Bedienpanel ausgelöst werden könnte, bzw. die kritischen Situationen können möglichst vermieden werden.

Eine Nachbarschaft zwischen den Tasten kann man - normalerweise ein befugtes Personal, z.B. ein Servicetechniker - bei Bedarf beliebig konfigurieren und ändern. Dabei sind üblicherweise zwei direkt nebeneinanderstehende Tasten als ein Nachbar füreinander zu verstehen. Alternative oder zusätzlich dazu, kann eine bestimmte Anzahl von den Tasten in einem bestimmten Bereich des Bedienpanels als die Nachbarn füreinander definiert werden. Eine der Tasten kann gleichzeitig als die erste und als die zweite Taste gelten. Somit können zwei oder mehrere Zuteilungen oder Eingruppierungen von den ersten und zweiten Tasten, die einander teilweise überlappen bzw. beeinflussen können, gleichzeitig ausgewertet werden. Dabei kann eine zweite Taste, deren Kapazität in der Prüfperiode geändert wird, durch die Steuereinheit als eine andere erste Taste ausgewertet werden.

Gemäß einer vorteilhaften Ausgestaltung der Erfindung, falls es zwei oder mehrere zweiten Tasten gibt, kann die Steuereinheit die aktivierte erste Taste annullieren, erst wenn die Anzahl der zweiten Tasten, deren Kapazität in der Prüfperiode geändert worden ist, eine vorgegebene Grenzzahl überschreitet.

Gemäß einer weiteren vorteilhaften Ausgestaltung der Erfindung kann die Steuereinheit die Betätigung der erste Taste annullieren, falls die Betätigungsdauer der ersten Taste über eine vorgegebene zweite Zeitperiode überschreitet, selbst wenn keine Kapazitätsänderung der zweiten Taste in der Prüfperiode erfolgte. Der Grund dafür ist, dass eine unabsichtliche Betätigung einer oder mehrerer Tasten in der Regel entweder ziemlich kurz oder ungewöhnlich lang sein sollte. Und eine Störung für oder bei einer Taste ist normalerweise ebenfalls eine ständige Störung, wie z.B. eine Taste wegen eines elektronischen Fehlers oder einer Verschmutzung defekt ging oder versagt. Die zweite Zeitperiode sollte somit deutlich länger ist als die erste Zeitperiode und/oder die Prüfperiode sein. Die erste und die zweite Zeitperiode können gleichzeitig mit derselben Startzeit, nacheinander oder unabhängig voneinander durchlaufen.

Gemäß einer anderen vorteilhaften Ausgestaltung der Erfindung kann die Steuereinheit ein Alarmsignal durch einen Alarmmelder generieren, wenn die Steuereinheit die betätigte erste Taste nach dem Ablauf der zweiten Zeitperiode annulliert. Der Alarmmelder kann in das Bedienpanel integriert oder als ein separates Gerät zum Aufzug angeordnet werden. Da die zweite Zeitperiode üblicherweise angemessen lang genug definiert wird, kann die Steuereinheit davon ausgehen, dass eine ungewöhnlich ständig betätigte Taste als eine Störung oder ein Fehler anzusehen ist. Um Sicherheit zu allen Zeiten - auch in einem Fall von einer ungewöhnlichen Nutzung oder einem Missbrauch des Bedienpanels - zu gewährleisten, wird ein Passagier, der sich eventuell des Bedienpanels noch bedient, über diese Annullierung der Taste informiert. Das Alarmsignal könnte ein optisches, akustisches und/oder textuelles Signal.

Gemäß einer weiteren vorteilhaften Ausgestaltung der Erfindung werden die Steuereinheit die Kapazitäten der kapazitiven Tasten durch die Steuereinheit auf deren vorgegebenen Sollkapazitätswerte kalibriert, wenn keine von den Tasten betätigt ist. Eine solche Kalibrierung kann nach einer vordefinierten Zeit periodisch automatisch durchgeführt werden. D.h., die Tasten des Bedienpanels dürfen erst kalibriert werden, nur wenn entweder alle Tasten nicht bestätigt werden oder eine Störung erkannt worden ist. Somit kann eine Kapazitätsdrift, die möglicherweise oder potentiell an einer kapazitiven Taste vorkommen könnte, kompensiert werden, wodurch die Steuereinheit Kapazitätsänderungen der Tasten präzise ermitteln und auswerten kann.

Ferner wird das Bedienpanel dazu konfiguriert, drahtlos mit einem externen Steuerungsmittel (z.B. Rechner oder Server) zu kommunizieren. Hierdurch lässt sich die Datenverbindung zwischen dem Bedienpanel und dem externen Steuerungsmittel in einfacher Weise etablieren, ohne dass beispielsweise Aufwand für eine Verlegung von elektrischen Leitungen nötig wäre. Je nachdem, ob das externe Steuerungsmittel relativ nahe zu dem Bedienpanel oder dem Aufzug angeordnet ist, d.h. sich beispielsweise im gleichen Gebäude befindet, oder ob das externe Steuerungsmittel weit entfernt angeordnet ist, können verschiedene Technologien für die drahtlose Kommunikation eingesetzt werden. Bei geringen Abständen kann z.B. ein lokales Funknetz (z.B. WLAN / Wifi) eingesetzt werden. Diese Information kann über die Datenverbindung an das externe Steuerungsmittel geleitet werden. Das externe Steuerungsmittel konnten vorher Kriterien ein programmiert worden sein, anhand derer das externe Steuerungsmittel beurteilen kann. Insbesondere kann das generierte Alarmsignal nach einer Hauptsteuerung des Aufzugs und/oder einer Fernzentrale weitergeleitet werden. D.h., je nachdem wie die Steuereinheit eine Kritizität dieser Störung - möglicherweise mit anderen ermittelten Parametern - ausgewertet, können verschiedene Massnahmen genommen werden, um entweder den Aufzug ausser Betrieb zu setzen oder vorläufig nur einige Funktionen einzuschränken, wie z.B. die Funktionen von DTO- und DTS-Tasten auszuschalten.

Gemäß einem zweiten Aspekt der Erfindung wird ein Bedienpanel für einen Aufzug zum Ausführen eines Verfahrens gemäß einer Ausführungsform des ersten Aspekts der Erfindung vorgeschlagen.

Gemäß einem dritten Aspekt der Erfindung wird ein Aufzug mit einem Bedienpanel gemäß einer Ausführungsform des zweiten Aspekts vorgesehen, wobei das Bedienpanel als Car Operation Panel (COP) oder Landing Operation Panel (LOP) des Aufzugs angeordnet ist.

Gemäß einem vierten Aspekt der Erfindung wird ein Computerprogrammprodukt gegeben, welches computerlesbare Anweisungen enthält, die bei Ausführung durch eine Steuereinrichtung eines Bedienpanels eines Aufzugs dazu anleiten, ein Verfahren gemäß einer Ausführungsform des ersten Aspekts auszuführen.

Gemäß einem fünften Aspekt der Erfindung wird ein Computerlesbares Medium mit einem darauf gespeicherten Computerprogrammprodukt gemäß einer Ausführungsform des vierten Aspekts vorgesehen.

Es wird darauf hingewiesen, dass einige der möglichen Merkmale und Vorteile der Erfindung hierin mit Bezug auf unterschiedliche Ausführungsformen des erfindungsgemäßen Bedienpanels einerseits und des erfindungsgemäßen Verfahrens andererseits beschrieben sind. Ein Fachmann erkennt, dass die Merkmale im Schutzumfang der beigefügten Ansprüche in geeigneter Weise kombiniert, übertragen, angepasst oder ausgetauscht werden können, um zu weiteren Ausführungsformen der Erfindung zu gelangen.

Nachfolgend wird eine vorteilhafte Ausführungsform der Erfindung unter Bezugnahme auf die beigefügten Figuren beschrieben, wobei weder die Figuren noch die Beschreibung als die Erfindung einschränkend auszulegen sind. Die Figuren sind lediglich schematisch und nicht maßstabsgetreu. Gleiche Bezugszeichen bezeichnen gleiche oder gleichwirkende Merkmale.

Es zeigen:
- FIG 1: Eine schematische Darstellung eines erfindungsgemäßen Bedienpanels für einen Aufzug,
- FIG 2: Ein Flussdiagramm für ein Ausführungsbeispiel für Ermittlung einer Betätigung einer kapazitiven Taste des Bedienpanels.

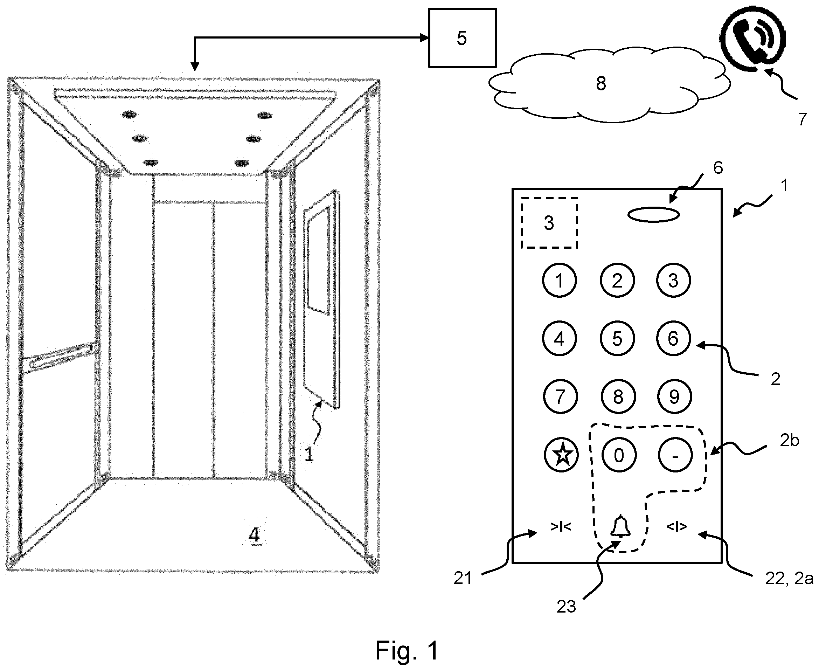

Fig. 1 zeigt ein erfindungsgemäßes Bedienpanel 1, z.B. ein COP für einen Aufzug 1. Das Bedienpanel 1 ist ein kapazitives Panel und umfasst mehrere kapazitive Tasten 2 und eine Steuereinheit 3. Jede Taste 2 weist eine unterschiedliche Kapazität in ihrem betätigten (oder aktivierten) Schaltzustand oder Stillzustand (oder nicht aktivierten Schaltzustand) auf. Aus diesem Grund kann die Steuereinheit 3 Betätigungen verschiedener Tasten 2 effektiv wahrnehmen und voneinander unterscheiden, indem sie eine Kapazitätsänderung jeder Taste 2 überwacht.

Zur besseren Darstellung einer Tastenbelegung solcher Tasten 2 wird das Bedienpanel 1 speziell extra unten links in der Figur vergrößert gezeigt. Die Tastenbelegung ist eine Standard-Zehnertastatur mit zwei Funktionstasten für temporäre Funktionen und einer Störungsmeldetaste 23, wobei die zwei Funktionstasten jeweils mit einem Zeichen «-» und «*» beschriftet sind. Die Steuereinheit 3, die z.B. in das Bedienpanel 1 integriert oder hinter diesem angeordnet ist, wird mit einem gestrichelten Kästchen dargestellt.

Unter den Tasten 2 ist es möglich so vorgesehen, dass mindestens eine erste Taste 2a und mindestens eine zweite Taste 2b, diese zu der ersten Taste 2a benachbart angeordnet ist, gegeben sind. Durch eine manuelle Betätigung wird eine Taste 2 als eine erste Taste 2a von der Steuereinheit 3 erkannt. Gleichzeitig wird mindestens eine zweite Taste 2b, die eine benachbarte Taste der ersten Taste 2a ist, von der Steuereinheit 3 identifiziert und überwacht. Falls noch weitere Tasten vorhanden sind, die nicht zu den benachbarten Tasten 2b gehören, können solche weiteren Tasten bei der Auswertung bzw. Steuerung der ersten Taste 2a ausser Betrachtung bleiben. Eine Taste 2 kann gleichzeitig sowohl als eine erste Taste 2a als auch als eine zweite Taste 2b für eine oder mehrere andere Tasten, welche als eine andere erste Taste gilt oder gelten, erkannt werden. In diesem Fall können alle ersten Tasten 2a gleichzeitig und abhängig von deren jeweiligen benachbarten zweiten Tasten 2b ausgewertet werden. Wenn man z.B. eine Türöffnungstaste (DTO) 22 drückt, gilt diese Taste dann als eine erste Taste 2a, während die Störungsmeldetaste 23, die Erdgeschoss-Zielruftaste «0» und die Taste «-» als die zweiten Tasten 2b sind. In der FIG 1 sind solche zweiten Tasten 2a zur erkennbaren Darstellung durch eine strichpunktierte Linie umgefasst. Ein anderes Beispiel, wenn die Türschließtaste (DTS) 21 eine erste Taste 2a ist, sind die Taste «^{∗}», die Störungsmeldetaste 23 und die Erdgeschoss-Zielruftaste «0» dementsprechend die zweiten Tasten 2b. Analog dazu könne wir in ähnlicher Weise ableiten, dass bei Betätigung der Fünftstockwerk-Zielruftaste «5», die sich als die erste Taste 2a verhält, die Tasten «1», «2», «3», «4», «6», «7», «8» und «9» dann die zweiten Tasten 2b sind.

Ferner umfasst das Bedienpanel 1 einen Alarmmelder 6. Wenn die Steuereinheit 3 eine dauerhaft betätigte erste Taste 2a deaktiviert oder annulliert bzw. als eine Störung erkennt, kann der Alarmmelder 6 ein Alarmsignal generieren. Dieses Alarmsignal kann zur einer Hauptsteuerung 5 des Aufzugs 4 und über ein Netzwerk 8 an eine Fernzentrale 7 weitergeleitet werden. In diesem Fall kann die Hauptsteuerung 6 den Betrieb des Aufzugs 4 unterbrechen oder nach der Auswertung der Steuereinheit 5 vorläufig nur einige Funktionen sperren, wie z.B. die Türsteuerung durch die DTS-/DTO-Taste zu verhindern.

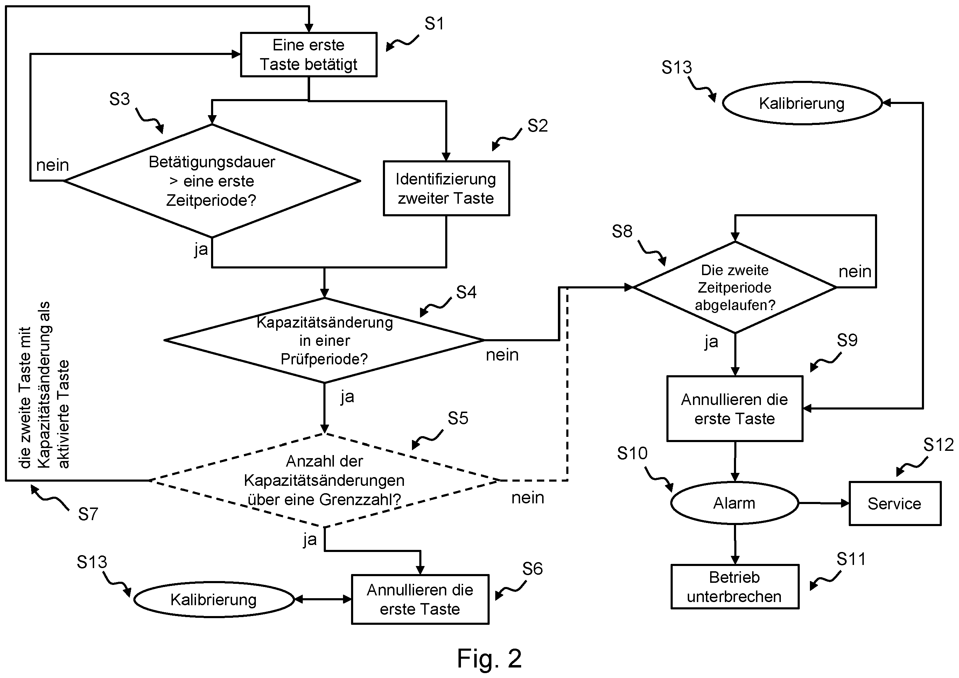

In FIG 2 werden die Funktionen eines Bedienpanel 1 gemäss FIG 1 bzw. ein Verfahren zum Bedienen eines Aufzugs 4 mit diesem Bedienpanel 1 dargestellt, wobei die entsprechenden Verfahrensschritte durch ein Flussdiagramm in folgenden Schritten S1 bis S14 veranschaulicht werden.
- S1:: Eine Taste 2 wird als eine betätige erste Taste 2a erkannt.
- S2:: Die Steuereinheit 3 erkannt diese Betätigung der ersten Taste 2b und identifiziert gleichzeitig mindestens eine zu der ersten Taste 2a benachbarte Taste als die zweite Taste 2b.
- S3:: Die Steuereinheit 3 prüft, ob die Betätigungsdauer der ersten Taste 2 eine erste Zeitperiode (z.B. eine oder zwei Sekunden ab der Tastenbetätigung) überschreitet. Wenn es nicht der Fall ist, bleibt diese Taste 2 als eine normale Taste aktiviert.
- S4:: Die Steuereinheit 3 prüft, ob die Kapazität einer der zweiten Tasten 2b während einer zweiten vorgegebenen Zeitperiode geändert wird.
- S5:: Falls mindestens eine Kapazitätsänderung in der zweiten Zeitperiode erfolgte, ist es weiter zu prüfen, wie viele zweite Tasten 2b gegeben sind, bei denen die Kapazität geändert worden ist. Da der Schritt S6 optional ist, wird dieser Block durch eine strichpunktierte Linie dargestellt.
- S6:: Beim Überschreiten der Anzahl solcher zweiten Tasten 2b eine vorgegebene Grenzzahl wird die erste Taste 2a annulliert. Wenn es nicht der Fall ist, wird es zu dem Verfahrensschritt S9 wechseln.
- S7:: Unabhängig davon, ob die Grenzzahl überschritten wird oder nicht, fangt eine Auswertung der zweiten Tasten 2b, an denen eine Kapazitätsänderung ermittelt wird, als für eine neue aktivierte Taste von dem Schritt S1 wieder an.
- S8:: Falls keine Kapazitätsänderung im Schritt S4 ermittelt wird oder die Anzahl der zweiten Tasten 2a, bei denen eine Kapazitätsänderung ermittelt wird, nicht die Grenzzahl überschreitet (Schritt S5), wird die Steuereinheit 3 weiter prüfen, ob die Aktivierungsdauer der ersten Taste 2a über eine zweite vorgegebene Zeitperiode hinausgeht.
- S9:: Wenn es der Fall ist, wird die erste Taste 2a von der Steuereinheit 3 annulliert, damit eine möglicherweise von einer Störung oder Fehlbedienung ausgelöste dauerhafte Aktivierung einer Taste vermieden werden kann. Wenn die erste Taste 2a z.B. eine DTO-Taste 22 ist, kann das bedeuten, dass die Schachttür und Kabinentür trotzdem geschlossen werden.
- S10:: Nach der Deaktivierung geniert die Steuereinheit 3 z.B. ein akustisches Alarmsignal durch einen Alarmmelder 6, um einen Passagier oder ein Servicepersonal auf die Störung bzw. Annullierung hinzuweisen.
- S11:: Danach oder gleichzeitig kann der Betrieb des Aufzugs 4 unterbrochen.
- S12:: Das generierte Alarmsignal wird nach einer Hauptsteuerung 5 des Aufzugs 4 und/oder einer Fernzentrale 7 weitergeleitet werden.
- S13:: Eine Kalibrierung kann nach der Annullierung der ersten Tasten 2a durchgeführt werden, wenn keine Taste 2 betätigt oder eine Störung erkannt worden ist.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele im Schutzumfang der beigefügten Ansprüche verwendet werden können. Bezugszeichen in den Ansprüchen sind nicht als Einschränkung anzusehen.

## Patentansprüche

1. Verfahren zum Bedienen eines Aufzugs (4) mit einem Bedienpanel (1), wobei das Bedienpanel (1) mehrere kapazitive Tasten (2) und eine Steuereinheit (3) aufweist, welche eine Kapazitätsänderung der kapazitiven Tasten (2) zur Erkennung einer Betätigung der Taste (2) auswertet,
**dadurch gekennzeichnet, dass**,
wenn eine Betätigung einer ersten Taste (2a) erkannt wird,
die Betätigungsdauer dieser ersten Taste (2a) eine vorgegebene erste Zeitperiode überschreitet, und
eine Betätigung mindestens einer zweiten, zu der ersten Taste (2a) benachbart angeordneten Taste (2b) erkannt wird, dann
die Betätigung der ersten Taste (2a) anhand einer Kapazitätsänderung der betätigten zweiten Taste (2b) derart gesteuert wird, dass die Steuereinheit (3) die Betätigung der ersten Taste (2a) annulliert, wenn die Betätigung der zweiten Taste (2b) während einer vorgegebenen Prüfperiode andauert.

2. Verfahren nach Anspruch 1, bei dem
die Steuereinheit (3) die Betätigung der ersten Taste (2a) annulliert, wenn es zwei oder mehrere zweiten Tasten (2b) gibt und die Anzahl der zweiten Tasten (2b), deren Kapazität in der Prüfperiode geändert wird, eine vorgegebene Grenzzahl überschreitet.

3. Verfahren nach Anspruch 1 oder 2, bei dem
eine der Tasten (2) gleichzeitig als die erste (2a) und als die zweite Taste (2b) gelten kann, wobei die zweite Taste (2b), deren Kapazität in der Prüfperiode geändert wird, durch die Steuereinheit (3) als eine andere erste Taste (2a) ausgewertet wird.

4. Verfahren nach einem der vorangehenden Ansprüche, bei dem die Steuereinheit (3) die Betätigung der ersten Taste (2a) annulliert, wenn die Betätigungsdauer der ersten Taste (2a) eine vorgegebene zweite Zeitperiode überschreitet.

5. Verfahren nach einem der vorangehenden Ansprüche, bei dem ein Alarmsignal durch einen Alarmmelder (6) generiert, wenn die betätigte erste Taste (2a) durch die Steuereinheit (3) nach dem Ablauf der zweiten Zeitperiode annulliert wird.

6. Verfahren nach Anspruch 5, bei dem
das Alarmsignal an eine Hauptsteuerung (6) und/oder an eine Fernzentrale (7) des Aufzugs (4) weitergeleitet wird.

7. Verfahren nach einem der vorangehenden Ansprüche, bei dem die Kapazitiven Tasten (2) durch die Steuereinheit (3) auf deren vorgegebenen Sollkapazitätswerte kalibriert werden, wenn keine von den Tasten (2) betätigt ist.

8. Bedienpanel (1) für einen Aufzug (4) zum Ausführen des Verfahrens nach einem der Ansprüche 1 bis 7, wobei das Bedienpanel (1) mehrere kapazitive Tasten (2) und einer Steuereinheit (3) aufweist, wobei die Steuereinheit (3) eine Betätigung und eine Betätigungsdauer der jeweiligen Tasten (2) erkennen kann, indem die Steuereinheit (3) eine Kapazitätsänderung der jeweiligen kapazitiven Tasten (2) ermitteln kann,
**dadurch gekennzeichnet, dass** bei Erkennung einer Betätigung einer ersten Taste (2a), wenn die Betätigungsdauer über eine vorgegebene erste Zeitperiode überschreitet, und einer Betätigung mindestens einer zweiten, zu der ersten Taste (2a) benachbart angeordneten Taste (2b) die Betätigung der ersten Taste (2a) anhand einer Kapazitätsänderung der betätigten zweiten Taste (2b) derart steuerbar ist, dass die Steuereinheit (3) die Betätigung der ersten Taste (2a) annullieren kann, wenn die Betätigung der zweiten Taste (2b) während einer vorgegebenen Prüfperiode andauert.

9. Bedienpanel (1) nach Anspruch 8, wobei
die Steuereinheit (3) derart ausgebildet ist, die betätigte erste Taste (2a) annullieren kann, wenn die Anzahl der zweiten Tasten (2b), deren Kapazität in der Prüfperiode geändert worden ist, eine vorgegebene Grenzzahl überschreitet.

10. Bedienpanel (1) nach einem der Ansprüche 8 bis 10, wobei die Steuereinheit (3) die betätigte erste Taste (2a) annullieren kann, wenn die Betätigungsdauer der ersten Taste (2a) über eine vorgegebene zweite Zeitperiode überschreitet.

11. Bedienpanel (1) nach einem der Ansprüche 8 bis 10, wobei die die Steuereinheit (3) die Kapazitiven Tasten (2) auf deren vorgegebenen Sollkapazitätswerte kalibrieren kann, wenn keine von den Tasten (2) betätigt ist.

12. Bedienpanel (1) nach einem der Ansprüche 8 bis 11, wobei die Steuereinheit (3) ein Alarmsignal mittels einen Alarmmelder (6) generieren kann, wenn die Steuereinheit (3) die betätigte erste Taste (2a) nach dem Ablauf der zweiten Zeitperiode deaktiviert.

13. Aufzug (4) mit einem Bedienpanel (1) gemäß einem der Ansprüche 8 bis 12 als Car Operation Panel (COP) oder Landing Operation Panel (LOP) dieses Aufzugs.

14. Computerprogrammprodukt, welches computerlesbare Anweisungen enthält, die bei Ausführung durch eine Steuereinrichtung (3) eines Bedienpanels (1) eines Aufzugs (4) dazu anleiten, ein Verfahren gemäß einem der Ansprüche 1 bis 7 auszuführen oder zu kontrollieren.

15. Computerlesbares Medium mit einem darauf gespeicherten Computerprogrammprodukt gemäß Anspruch 14.

## Claims

1. Method for operating an elevator (4) comprising an operating panel (1), the operating panel(1) having a plurality of capacitive buttons (2) and a control unit (3) which evaluates a change in capacitance of the capacitive buttons (2) in order to detect an actuation of the button (2),
**characterized in that**,
if an actuation of a first button (2a) is detected,
the actuation duration of this first button (2a) exceeds a predetermined first time period, and
an actuation of at least one second button (2b) arranged adjacent to the first button (2a) is detected, then
the actuation of the first button (2a) is controlled on the basis of a change in capacitance of the actuated second button (2b) such that the control unit (3) cancels the actuation of the first button (2a) if the actuation of the second button (2b) continues during a predetermined check period.

2. Method according to claim 1, wherein
the control unit (3) cancels the actuation of the first button (2a) if there are two or more second buttons (2b) and the number of the second buttons (2b), the capacitance of which is changed in the check period, exceeds a predetermined limit number.

3. Method according to either claim 1 or claim 2, wherein
one of the buttons (2) can be in effect at the same time as the first button (2a) and the second button (2b), the second button (2b), the capacitance of which is changed in the check period, being evaluated by the control unit (3) as another first button (2a).

4. Method according to any of the preceding claims, wherein
the control unit (3) cancels the actuation of the first button (2a) if the actuation duration of the first button (2a) exceeds a predetermined second time period.

5. Method according to any of the preceding claims, wherein
an alarm signal is generated by an alarm indicator (6) if the actuated first button (2a) is canceled by the control unit (3) after the second time period has elapsed.

6. Method according to claim 5, wherein
the alarm signal is forwarded to a main controller (6) and/or to a remote control center (7) of the elevator (4).

7. Method according to any of the preceding claims, wherein
the capacitive buttons (2) are calibrated by the control unit (3) to their predetermined target capacitance values if none of the buttons (2) are actuated.

8. Operating panel (1) for an elevator (4) for carrying out the method according to any of claims 1 to 7, the operating panel (1) having a plurality of capacitive buttons (2) and a control unit (3), the control unit (3) being able to detect an actuation and an actuation duration of the respective buttons (2) by the control unit (3) being able to determine a change in capacitance of the respective capacitive buttons (2),
**characterized in that**, when an actuation of a first button (2a) is detected, the actuation duration exceeds a predetermined first time period, and an actuation of at least one second button (2b) arranged adjacent to the first button (2a) is detected, the actuation of the first button (2a) can be controlled on the basis of a change in capacitance of the actuated second button (2b) such that the control unit (3) can cancel the actuation of the first button (2a) if the actuation of the second button (2b) continues during a predetermined check period.

9. Operating panel (1) according to claim 8, wherein
the control unit (3) is designed such that it can cancel the actuated first button (2a) if the number of the second buttons (2b), the capacitance of which has been changed in the check period, exceeds a predetermined limit number.

10. Operating panel (1) according to any of claims 8 to 10, wherein
the control unit (3) can cancel the actuated first button (2a) if the actuation duration of the first button (2a) exceeds a predetermined second time period.

11. Operating panel (1) according to any of claims 8 to 10, wherein the control unit (3) can calibrate the capacitive buttons (2) to their predetermined target capacitance values if none of the buttons (2) are actuated.

12. Operating panel (1) according to any of claims 8 to 11, wherein
the control unit (3) can generate an alarm signal by means of an alarm indicator (6) if the control unit (3) deactivates the actuated first button (2a) after the second time period has elapsed.

13. Elevator (4) comprising an operating panel (1) according to any of claims 8 to 12 as a Car Operation Panel (COP) or Landing Operation Panel (LOP) of said elevator.

14. Computer program product which contains computer-readable instructions which, when executed by a control device (3) of an operating panel (1) of an elevator (4), instruct to carry out or control a method according to any of claims 1 to 7.

15. Computer-readable medium having a computer program product according to claim 14 stored thereon.

## Revendications

1. Procédé permettant la manoeuvre d'un ascenseur (4) comportant un tableau de manoeuvre (1), le tableau de manoeuvre (1) présentant plusieurs touches (2) capacitives et une unité de commande (3) qui évalue une modification de capacité des touches (2) capacitives pour la détection d'un actionnement de la touche (2),
**caractérisé en ce que**
lorsqu'un actionnement d'une première touche (2a) est détecté,
que la durée d'actionnement de ladite première touche (2a) dépasse une première période de temps prédéterminée, et
qu'un actionnement d'au moins une seconde touche (2b) disposée à proximité de la première touche (2a) est détecté, alors
l'actionnement de la première touche (2a) est commandé au moyen d'une modification de capacité de la seconde touche (2b) actionnée de telle sorte que l'unité de commande (3) annule l'actionnement de la première touche (2a) lorsque l'actionnement de la seconde touche (2b) dure pendant une période d'essai prédéterminée.

2. Procédé selon la revendication 1, dans lequel
l'unité de commande (3) annule l'actionnement de la première touche (2a) lorsqu'il y a deux secondes touches (2b) ou plus et que le nombre de secondes touches (2b) dont la capacité est modifiée pendant la période d'essai dépasse un nombre limite prédéterminé.

3. Procédé selon la revendication 1 ou 2, dans lequel
l'une des touches (2) peut être considérée simultanément comme la première touche (2a) et comme la seconde touche (2b), la seconde touche (2b) dont la capacité est modifiée pendant la période d'essai étant évaluée par l'unité de commande (3) comme une autre première touche (2a).

4. Procédé selon l'une des revendications précédentes, dans lequel
l'unité de commande (3) annule l'actionnement de la première touche (2a) lorsque la durée d'actionnement de la première touche (2a) dépasse une seconde période de temps prédéterminée.

5. Procédé selon l'une des revendications précédentes, dans lequel
un signal d'alarme est généré par un détecteur d'alarme (6) lorsque la première touche (2a) actionnée est annulée par l'unité de commande (3) après l'expiration de la seconde période de temps.

6. Procédé selon la revendication 5, dans lequel
le signal d'alarme est transmis à un dispositif de commande principal (6) et/ou à un central à distance (7) de l'ascenseur (4).

7. Procédé selon l'une des revendications précédentes, dans lequel
les touches (2) capacitives sont étalonnées par l'unité de commande (3) sur leurs valeurs de capacité de consigne prédéterminées lorsqu'aucune des touches (2) n'est actionnée.

8. Tableau de manoeuvre (1) pour un ascenseur (4) permettant d'exécuter le procédé selon l'une des revendications 1 à 7, dans lequel le tableau de manoeuvre (1) présente plusieurs touches (2) capacitives et une unité de commande (3), l'unité de commande (3) pouvant détecter un actionnement et une durée d'actionnement des touches (2) respectives par le fait que l'unité de commande (3) peut déterminer une modification de capacité des touches (2) capacitives respectives,
**caractérisé en ce que**, lors de la détection d'un actionnement d'une première touche (2a), lorsque la durée d'actionnement dépasse une première période de temps prédéterminée, et d'un actionnement d'au moins une seconde touche (2b) disposée à proximité de la première touche (2a), l'actionnement de la première touche (2a) peut être commandé au moyen d'une modification de capacité de la seconde touche (2b) actionnée de telle sorte que l'unité de commande (3) peut annuler l'actionnement de la première touche (2a) lorsque l'actionnement de la seconde touche (2b) dure pendant une période d'essai prédéterminée.

9. Tableau de manoeuvre (1) selon la revendication 8, dans lequel
l'unité de commande (3) est configurée de telle sorte que la première touche (2a) actionnée peut être annulée lorsque le nombre de secondes touches (2b) dont la capacité a été modifiée pendant la période d'essai dépasse un nombre limite prédéterminé.

10. Tableau de manoeuvre (1) selon l'une des revendications 8 à 10, dans lequel
l'unité de commande (3) peut annuler la première touche (2a) actionnée lorsque la durée d'actionnement de la première touche (2a) dépasse une seconde période de temps prédéterminée.

11. Tableau de manoeuvre (1) selon l'une des revendications 8 à 10, dans lequel
l'unité de commande (3) peut étalonner les touches (2) capacitives sur leurs valeurs de capacité de consigne prédéterminées lorsqu'aucune des touches (2) n'est actionnée.

12. Tableau de manoeuvre (1) selon l'une des revendications 8 à 11, dans lequel
l'unité de commande (3) peut générer un signal d'alarme au moyen d'un détecteur d'alarme (6) lorsque l'unité de commande (3) désactive la première touche (2a) actionnée après l'expiration de la seconde période de temps.

13. Ascenseur (4) comportant un tableau de manoeuvre (1) selon l'une des revendications 8 à 12 en tant que tableau de manoeuvre en cabine (COP) ou tableau de manoeuvre de débarquement (LOP) dudit ascenseur.

14. Produit programme informatique contenant des instructions lisibles par ordinateur qui, lorsqu'elles sont exécutées par un appareil de commande (3) d'un tableau de manoeuvre (1) d'un ascenseur (4), amènent l'exécution ou le contrôle d'un procédé selon l'une des revendications 1 à 7.

15. Support lisible par ordinateur sur lequel est stocké un produit programme informatique selon la revendication 14.
